(19) Europäisches Patentamt
European Patent Office
Office européen des brevets

(11) Veröffentlichungsnummer: **0 091 401**
**B1**

(12) # EUROPÄISCHE PATENTSCHRIFT

(45) Veröffentlichungstag der Patentschrift: **20.11.86**

(51) Int. Cl.[4]: **C 08 J 5/24**, C 08 F 20/36, C 08 F 2/48, C 08 L 63/00

(21) Anmeldenummer: **83810126.9**

(22) Anmeldetag: **25.03.83**

(54) **Herstellung von Prepregs aus cellulosehaltigen Fasern unter Verwendung wässriger Harzzusammensetzungen.**

(30) Priorität: **03.04.82 GB 8209955**
**05.08.82 GB 8222600**

(43) Veröffentlichungstag der Anmeldung:
**12.10.83 Patentblatt 83/41**

(45) Bekanntmachung des Hinweises auf die Patenterteilung:
**20.11.86 Patentblatt 86/47**

(84) Benannte Vertragsstaaten:
**CH DE FR GB IT LI NL SE**

(56) Entgegenhaltungen:
**EP - A - 0 070 253**
**FR - A - 1 415 332**
**FR - A - 2 017 090**
**FR - A - 2 240 814**
**FR - A - 2 341 613**

(73) Patentinhaber: **CIBA-GEIGY AG, Klybeckstrasse 141, CH-4002 Basel (CH)**

(72) Erfinder: **Irving, Edward, Dr., 41, Swaffham Road, Burwell Cambridge CB5 0AN (GB)**

**EP 0 091 401 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Vorliegende Erfindung betrifft ein Verfahren zur Herstellung heisshärtbarer Prepregs aus cellulosehaltigen Fasern sowie durch Heisshärtung solcher Prepregs erhaltene Verbundstoffe.

Aus heisshärtbaren cellulosehaltigen Prepregs hergestellte Laminate werden industriell verwendet, zum Beispiel bei der Erzeugung von Sockelplatten für gedruckte Schaltungen. Diese faserverstärkten Materialien werden allgemein dadurch hergestellt, dass man cellulosehaltige Fasern mit einer wässrigen Lösung eines Phenol/Formaldehydharzes imprägniert, die Fasern erhitzt, um sie zu trocknen, sie mit einer Lösung eines Epoxidharzes in einem organischen Lösungsmittel nochmals imprägniert und dann unter Bildung eines heisshärtbaren Prepregs trocknet. Schliesslich wird der Prepreg unter Druck (üblicherweise in Form übereinander angeordneter Schichten) erhitzt, um das Epoxidharz zu härten und so einen Verbundstoff zu bilden.

Der Grund für die Notwendigkeit, zwei getrennte Imprägnierungs- und Trocknungsstufen durchzuführen, besteht darin, dass Epoxidharze im allgemeinen für eine direkte Imprägnierung cellulosehaltiger Fasern zu hydrophob sind; die Fasern müssen zunächst durch Behandlung mit einer wässrigen Phenolharzlösung weniger hydrophil gemacht werden.

Wegen der Notwendigkeit für zwei Imprägnierungsstufen und zwei Trocknungsstufen ist die Durchführung des Verfahrens verhältnismässig teuer, langsam und kompliziert. Es besitzt ferner den Nachteil, dass für die zweite Imprägnierung ein organisches Lösungsmittel erforderlich ist, wodurch mögliche Gefahren bezüglich Toxizität und Brennbarkeit sowie Kosten zur Rückgewinnung des organischen Lösungsmittels entstehen.

Es wurde nun gefunden, dass man diese Nachteile im wesentlichen durch die Anwendung eines Verfahrens überwinden kann, das eine einzige Imprägnierungsstufe mit einer wässrigen heisshärtbaren Formulierung umfasst, die ein Epoxidharz zusammen mit einem bestimmten photopolymerisierbaren Harz enthält.

Die britische Patentschrift 1 006 587 beschreibt Addukte von Diglycidyläthern mit (Meth)acrylsäure. Unter den offenbarten Addukten finden sich solche der Formel

$$CH_2{=}CHCOOCH_2CH(OH)CH_2{-}O{+}ROCH_2CH(OH)CH_2O{+}_nROCH_2CH(OH)COCH{=}Ch_2CH_2O \qquad I$$

worin R für einen sich von einem Alkandiol oder Polyalkylendiol ableitenden zweiwertigen aliphatischen Rest steht und n 0 bis 20 ist. Die Addukte werden unter Verwendung von Peroxydinitiatoren heisspolymerisiert und gehärtet.

In der britischen Patentschrift 1 139 100 werden polymerisierbare, endständig ungesättigte und von nicht umgesetzten Epoxigruppen freie Produkte beschrieben, die durch Umsetzung von (a) 1 Mol eines Diepoxids, (b) 0,5 bis 0,9 Mol einer Dicarbonsäure und (c) 1,0 bis 0,2 Mol Acryl-, Methacryl- oder Crotonsäure oder eines Halbesters der Fumar- oder Maleinsäure hergestellt werden. Die Reaktionsfolge umfasst vorzugsweise eine anfängliche Reaktion zwischen (a) und (b) zur Bildung eines vorverlängerten Epoxidharzes und danach dessen Reaktion mit der ungesättigten Monocarbonsäure. Das Epoxidharz (a) ist ein Diglycidyläther eines zweiwertigen Phenols oder Alkohols. Die Produkte werden mittels Peroxydinitiatoren polymerisiert und gehärtet.

In der britischen Patentschrift 1 362 906 sind Addukte aus (Meth)acrylsäure mit Epoxidharzen beschrieben, die man durch Vorverlängerung eines Epoxidharzes mit einem Polyester mit Carboxylendgruppen erhält. Als Ausgangsepoxidharz kann ein Diglycidyläther, ein Diglycidylester oder eine N-heterocyclische Polyglycidylverbindung wie ein N,N-Diglycidylhydantoin vorliegen. Die Addukte mit (Meth)acrylatendgruppen lassen sich mit Radikalinitiatoren polymerisieren und sind zur Herstellung von Formkörpern verwendbar.

Die britische Patentschrift 1 367 207 beschreibt Addukte von n Mol (Meth)acrylsäure mit 1 Mol einer Polyglycidylverbindung der Formel

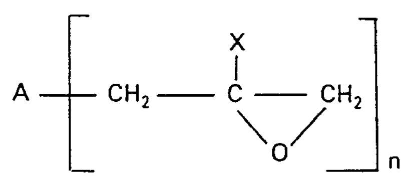

II

worin A einen Rest mit mindestens einer Gruppe der Formel

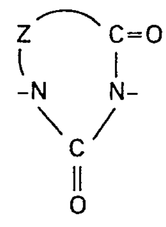

III

darstellt, worin Z für einen zweiwertigen, zur Ergänzung zu einem 5- oder 6gliedrigen heterocyclischen Ring erforderlichen Rest darstellt, X für $-H$ oder $-CH_3$ steht und n 2 oder 3 ist. Zu den bevorzugten Polyglycidylverbindungen zählen Diglycidylderivate von Hydantoinen. In den Beispielen werden Diacrylate durch Vorverlängerung von 1-Glycidyl-3-(2'-glycidyloxy-n-propyl)-5,5-dimethylhydantoin mit Sebacinsäure und Umsetzung des vorverlängerten Harzes mit Acrylsäure hergestellt. Die Addukte lassen sich mittels Radikalinitiatoren polymerisieren.

In der britischen Patentschrift 1 399 135 wird die Härtung dieser Addukte mit ionisierender

Strahlung offenbart. Dieses Patent enthält eine gattungsmässige Offenbarung bezüglich der Verwendung vorverlängerter Epoxidharze, nämlich dass mehr als zwei heterocyclische Reste enthaltende Polyglycidylverbindungen durch Umsetzung von Dicarbonsäuren mit Diglycidylverbindungen im entsprechenden Molverhältnis hergestellt werden können.

In der britischen Patentschrift 1 400 286 wird die Härtung der (Meth)acrylataddukte aus der britischen Patentschrift 1 362 906 mit ionisierender Strahlung beschrieben.

Aus der britischen Patentschrift 1 456 486 sind lufttrocknende, lichthärtbare Überzugszusammensetzungen auf Grundlage eines Produkts bekannt, das man durch Umsetzung von mindestens 60% der Epoxidgruppen eines Polyepoxids mit 0,01 bis 0,5 NH-Äquivalenten Ammoniak, eines aliphatischen oder cycloaliphatischen primären oder sekundären Amins oder eines Gemischs dieser Verbindungen pro Epoxidäquivalent und anschliessend mit 0,99 bis 0,5 Carboxyläquivalenten Acryl- und/oder Methacrylsäure erhält. Speziell erwähnte Polyepoxide sind dabei die Glycidyläther mehrwertiger Alkohole (einschliesslich 1,4-Butandiol) und Phenole sowie Polyglycidylester; aromatische Polyepoxide werden bevorzugt. Die Epoxid/Ammoniak- und Epoxid/Aminprodukte sollen freie Epoxidgruppen enthaltende 2-Hydroxypropyläther sein. Es heisst, dass die Überzugszusammensetzungen sehr rasch härten, sogar in Gegenwart von Luftsauerstoff, insbesondere bei Verwendung α-substituierter Benzoine als Photoinitiatoren, und dass sie sich besonders für Papier- und Kartonüberzüge eignen.

Die britische Patentschrift 1 489 425 offenbart lichthärtbare, aus einem modifizierten Epoxidharz und einem Photosensibilisator bestehende Harzzusammensetzungen. Das modifizierte Epoxidharz besitzt ein Molekulargewicht von 700 bis 5000 und enthält polymerisierbare ungesättigte Reste, die über Esterbindungen an die Hauptkette gebunden sind, um dem Harz ein Doppelbindungsäquivalentgewicht von 200 bis 3000 zu verleihen, sowie auch an die Hauptkette gebundene -COOH-Gruppen, damit das Harz eine Säurezahl im Bereich 30 bis 150 aufweist. Bei einem der angegebenen Herstellungswege handelt es sich um die Reaktion eines Epoxidharzes mit einer Dicarbonsäure zur Erzeugung eines vorverlängerten Harzes, das dann mit (Meth)acrylsäure zu einem Harz mit (Meth)acrylatendgruppen umgesetzt wird, welches seinerseits (über seine -OH-Gruppen) mit einem Dicarbonsäureanhydrid zur Reaktion gebracht wird. Erwähnte, zur Vorverlängerung geeignete Dicarbonsäuren sind unter anderem verschiedene gesättigte und ungesättigte aliphatische Säuren. In einem Beispiel wird ein Bisphenol-A-diglycidyläther mit Adipinsäure vorverlängert und das vorverlängerte Harz mit Acrylsäure zu einem Zwischenprodukt umgesetzt.

Aus der britischen Patentschrift 1 521 933 sind Harze bekannt geworden, die vor der Belichtung mit aktinischer Strahlung wasserlöslich sind, jedoch bei Belichtung mit aktinischer Strahlung polymerisieren und wasserunlöslich werden, wobei diese Harze der allgemeinen Formel

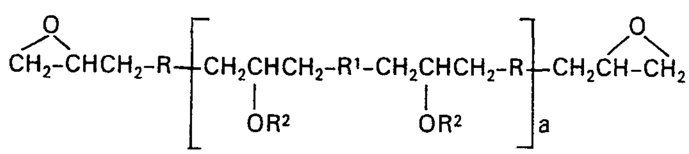

IV

entsprechen, worin a eine ganze Zahl mit einem Durchschnittswert von mindestens 1, jedoch vorzugsweise nicht mehr als 100 ist, R und $R^1$ je für eine Gruppe der Formel

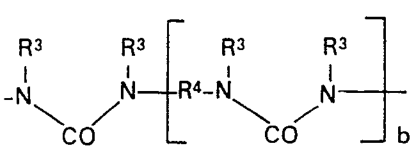

V

oder $-O-(OC)_c-R^5-(CO)_c-O-$, $R^6$ jeweils für ein Wasserstoffatom oder eine Gruppe der Formel $-(CH_2NH)_dCOC(R^6)=CH_2$, mit der Massgabe, dass mindestens 1 und vorzugsweise mindestens 25% der 2a Gruppen $R^2$ von einem Wasserstoffatom verschieden sind, $R^3$ jeweils für eine Alkylgruppe mit 1 bis 4 Kohlenstoffatomen bzw. paarweise für eine Gruppe der Formel

$-CH_2CH_2-$, $-C(R^7R^8)CO-$, 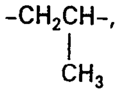

$-CH_2CH_2CH_2-$, $-COCO-$, $-COCOCO-$ oder $-COC(OH)_2CO-$ und $R^4$ für einen zweiwertigen aliphatischen, cycloaliphatischen oder araliphatischen Rest mit 1 bis 8 Kohlenstoffatomen, insbesondere eine Alkylengruppe mit 1 bis 6 Kohlenstoffatomen, stehen, b, c, und d je null oder 1 sind, $R^5$ eine geradkettige oder verzweigte aliphatische Gruppe mit 2 bis 20 Atomen, wie eine solche mit 2 bis 9 Kohlenstoffatomen, insbesondere eine gegebenenfalls durch eine oder mehrere Carbonyloxygruppen oder ein oder mehrere Äthersauerstoffatome unterbrochene Alkylengruppe oder, falls alle c 1 sind, gegebenenfalls auch eine Gruppe der Formel

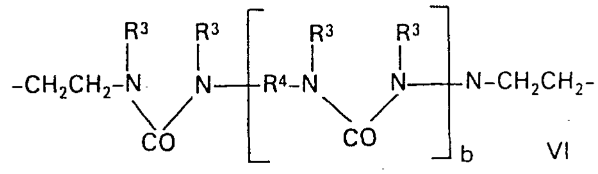

VI

$R^6$ ein Wasserstoffatom oder eine Alkylgruppe

mit 1 bis 4 Kohlenstoffatomen sowie $R^7$ und $R^8$ je ein Wasserstoffatom oder eine Methyl- oder Äthylgruppe bedeuten.

Die britische Patentschrift 1 537 909 beschreibt UV-vernetzbare, Vinyl- und Carboxygruppen enthaltende Urethanharze, die durch Umsetzung eines Epoxidharzes mit (Meth)acrylsäure, so dass 60% bis 100% der Epoxidgruppen in β-Hydroxyestergruppen umgewandelt werden, teilweise Überführung dieser Hydroxygruppen in die entsprechenden Urethane durch Reaktion mit einem Isocyanat und Umsetzung der verbleibenden Hydroxygruppen mit einem Dicarbonsäureanhydrid hergestellt werden. Das Epoxidharz kann durch Reaktion mit z.B. aliphatischen oder aromatischen Disäuren vorverlängert werden. In einem Beispiel wird ein Diglycidyläther von Bisphenol A mit Adipinsäure vorverlängert und dann mit Acrylsäure zu einem Zwischenprodukt umgesetzt.

Aus der europäischen Patentschrift 0 008 837 ist eine strahlungshärtbare flüssige Überzugszusammensetzung auf Grundlage (a) eines mindestens eine (Meth)acryloylgruppe enthaltenden Epoxidharzes, (b) eines Photoinitiators und (c) eines Vernetzungsmittels für die Epoxidgruppen in (a) bekannt. Das Harz (a) ist durch Umsetzung eines Epoxidharzes mit einem Unterschuss von (i) (Meth)acrylsäure oder (ii) einem Halbester eines hydroxysubstituierten (Meth)acrylats und einer Polycarbonsäure bzw. -anhydrid erhältlich. Als Epoxidharz kann ein Harz auf Hydantoingrundlage vorliegen. Zahlreiche Typen Vernetzungsmittel (c) werden angegeben, wobei die bei Raumtemperatur aktiven bevorzugt werden. In einer speziellen Ausführungsform wird dem Harz (a) ein Emulgator zugesetzt, so dass es nach Vermischen mit einem geeigneten Vernetzungsmittel wie einem Polyaminoamid mit Wasser verdünnt werden kann. Die Härtung der Zusammensetzung erfolgt in zwei Stufen:

in der ersten Stufe wird sie mit UV-Licht bestrahlt, und in der zweiten Stufe erfolgt die Aushärtung durch Reaktion der Epoxidgruppen mit (c).

Die europäische Patentschrift 0 030 213 beschreibt eine photovernetzbare Schicht, die nach Belichtung mit Wasser entwickelt werden kann und aus einem vernetzbaren ungesättigten Monomer oder Oligomer auf Grundlage mit (Meth)-acrylsäure modifizierter Epoxidharze mit einer Säurezahl von weniger als 0,2 sowie einem Photoinitiator besteht. In einem Beispiel wird dort ein Addukt von Acrylsäure mit einem durch Vorverlängerung von Neopentylglykoldiglycidyläther mit Bisphenol A erhaltenen Epoxidharz verwendet.

Die U.S.-Patentschrift 4 309 529 offenbart in Wasser dispergierbare, durch Energie härtbare Polyester mit Hydantoingruppen sowie α-Methylengruppen (=$CH_2$) an der «Hauptkette». Diese Polyester enthalten wiederkehrende Einheiten der Formel:

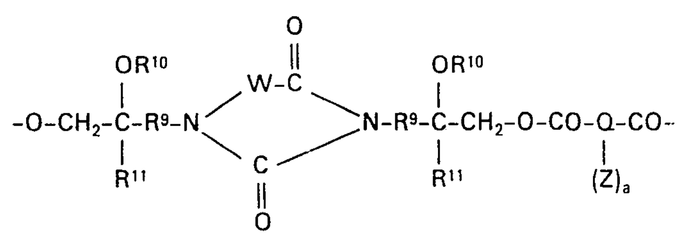
VII

worin $R^9$ eine Einfachbindung oder eine Alkylengruppe gegebenenfalls mit einem Kettensauerstoffatom darstellt, $R^{10}$ für $-H$, $-COR^{12}$ oder $-CONHR^{13}$, $R^{11}$ für $-H$ oder $-CH_3$, wobei $R^{12}$ Alkyl oder gegebenenfalls durch Phenyl oder Carboxyl substituiertes Alkenyl und $R^{13}$ einen aliphatischen oder aromatischen Kohlenwasserstoffrest bedeuten, W für eine zweiwertige, zur Ergänzung zu einem 5- oder 6gliedrigen Ring erforderliche Gruppe, Q für den zweiwertigen oder dreiwertigen Rest mit bis zu 40 Kohlenstoffatomen und gegebenenfalls Kettensauerstoffatome enthaltenden Kohlenwasserstoffdi- oder -tricarbonsäuren nach Wegnahme der aktiven Wasserstoffe von den -COOH-Gruppen und Z für -COOH stehen sowie a 0 oder 1 ist, aber nur für nicht mehr als 20 Mol-% der Säuren 1 sein kann.

In der erfindungswesentlichen Beschreibung wurde ausgeführt, dass mindestens 10 Mol-% der Säuren, von denen sich Q ableitet, α-Methylengruppen tragen sollen. Die Polyester werden allgemein durch Umsetzung eines heterocyclischen Diepoxids mit einer Dicarbonsäure hergestellt; wird ein Überschuss Diepoxid eingesetzt, so erhält man Polyester mit Epoxidendgruppen, die mit (Meth)acrylsäure umgesetzt werden können. Dabei werden zahlreiche Diglycidylderivate von Hydantoinen zur Verwendung als heterocyclisches Diepoxid vorgeschlagen. Als Dicarbonsäuren werden unter anderem zahlreiche gesättigte und ungesättigte aliphatische und aromatische Säuren erwähnt. Damit die Polyester α-Methylengruppen enthalten, muss mindestens ein Teil der Dicarbonsäurekomponente eine α-Methylensäure sein. Die in den Beispielen hergestellten Polyester tragen teilweise Acrylatendgruppen.

Es wurde nun ein Verfahren zur Herstellung von Prepregs gefunden, bei dem man cellulosehaltige Fasern mit einer wässrigen Zusammensetzung imprägniert, die aus (a) einem photopolymerisierbaren Harz und (b) einem Expoxidharz, vorzugsweise in Gegenwart eines Photosensibilisators für (a) und eines hitzeaktivierbaren Härters für (b), besteht, und dann die imprägnierten Fasern mit aktinischer Strahlung belichtet, so dass (a) photopolymerisiert wird, wobei (a) der Formel

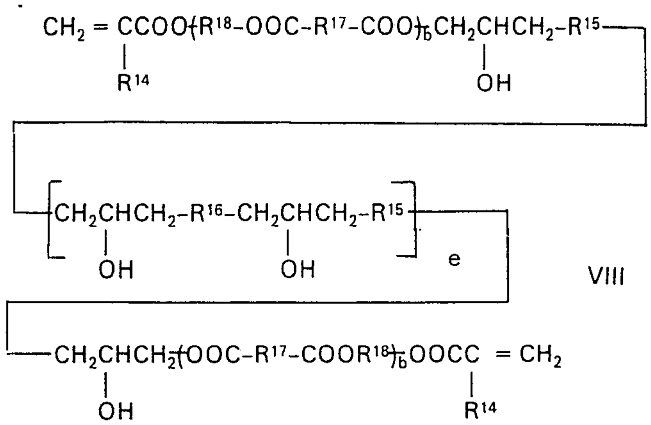

VIII

entspricht, worin b null oder 1 und e eine ganze Zahl von mindestens 1 ist, $R^{14}$ jeweils für ein Wasserstoffatom oder eine Methylgruppe, $R^{15}$ jeweils für den zweiwertigen Rest einer Verbindung mit zwei direkt an ein Sauerstoff-, Stickstoff- oder Schwefelatom bzw. -atome gebundenen Glycidylgruppen nach Wegnahme dieser beiden Glycidylgruppen, $R^{16}$ jeweils für den zweiwertigen Rest eines zweiwertigen Alkohols, eines zweiwertigen Phenols, einer Dicarbonsäure oder einer zwei unter Amid- und Imidgruppen ausgewählte Gruppen enthaltenden Verbindung nach Wegnahme von zwei endständigen, an ein Sauerstoff- oder Stickstoffatom bzw. -atome gebundenen Wasserstoffatomen, $R^{17}$ jeweils für eine Alkylengruppe mit 1 bis 6 Kohlenstoffatomen, eine Alkenylgruppe mit 2 bis 10 Kohlenstoffatomen, eine Arylengruppe mit 6 bis 10 Kohlenstoffatomen oder eine Cycloalkylen- oder Cycloalkenylengruppe mit 5 bis 8 Kohlenstoffatomen und $R^{18}$ jeweils für eine zweiwertige aliphatische, cycloaliphatische oder araliphatische Gruppe mit 2 bis 8 Kohlenstoffatomen stehen, mit der Massgabe, dass mindestens 25% der Summe der (e + 1) $R^{15}$- und e $R^{16}$-Gruppen je eine Gruppe der Formel

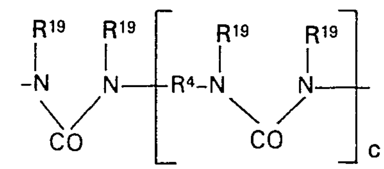

IX

oder eine Gruppe der Formel

$$-O(OC)_d-R^{20}-(CO)_d-O- \qquad X$$

darstellen, worin $R^4$ die oben angegebene Bedeutung hat, c und d je null oder 1 sind, $R^{19}$ jeweils eine Alkylgruppe mit 1 bis 4 Kohlenstoffatomen bzw. Paare $R^{19}$ zusammen eine Gruppe der Formel

$-CH_2CH_2-$, $-C(R^{21}R^{22})CO-$, 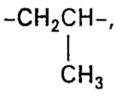

$-CH_2CH_2CH_2-$ oder $-COCO-$ bedeuten, $R^{20}$ eine geradkettige oder verzweigte aliphatische Gruppe mit 2 bis 20 Kohlenstoffatomen oder, falls alle d 1 sind, gegebenenfalls auch eine Gruppe der Formel

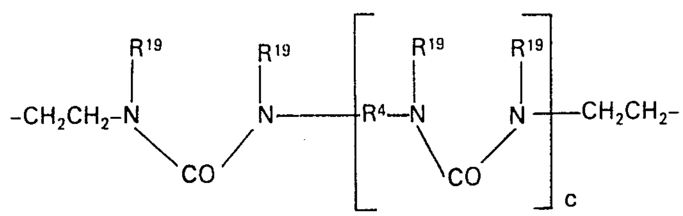

XI

darstellt sowie $R^{21}$ und $R^{22}$ entweder je für ein Wasserstoffatom oder eine geradkettige oder verzweigte Alkylgruppe mit bis zu 9 Kohlenstoffatomen oder zusammen für eine Tetramethylen-, Pentamethylen-, Methylpentamethylen- oder Hexamethylengruppe stehen.

Die Harze der Formel VIII sind zwar nicht unbedingt völlig löslich in Wasser, doch sind sie damit mischbar und fördern so die Imprägnierung der Fasern mit dem Expoxidharz.

Bevorzugt werden solche Harze der Formel VIII, worin e eine ganze Zahl von höchstens 10, insbesondere von 1 bis 5, ist. Vorzugsweise stellen höchstens 75% der Summe der (e + 1) $R^{15}$- und e $R^{16}$-Gruppen eine Gruppe der Formel IX oder X dar, worin d 1 ist, und mindestens 25% der Summe der Gruppen $R^{15}$ und $R^{16}$ bedeuten entweder (i) eine gegebenenfalls in der Kette durch ein oder mehrere Äthersauerstoffatome unterbrochene Oxyalkylenoxygruppe mit 2 bis 40 Kohlenstoffatomen, d.h. eine Gruppe der Formel X, worin d null ist, oder eine nicht der Formel IX oder X entsprechende Oxyalkylenoxygruppe mit 21 bis 40 Kohlenstoffatomen oder insbesondere (ii) eine Oxyarylenoxygruppe mit 6 bis 18 Kohlenstoffatomen.

Ferner werden Verbindungen der Formel VIII bevorzugt, worin mindestens 25% der Gruppen $R^{15}$ und $R^{16}$ je eine Oxyalkylenoxygruppe, deren Alkylenkomponente eine Kette mit 3 bis 6 aufeinanderfolgenden Kohlenstoffatomen oder eine durch ein oder mehrere Äthersauerstoffatome

unterbrochene Kette von 4 bis 28 Kohlenstoffatomen ist, eine Oxyphenylenoxygruppe oder eine Gruppe der Formel

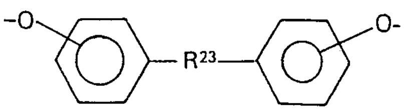

XII

worin $R^{23}$ für eine Kohlenstoff-Kohlenstoffbindung, ein Äthersauerstoffatom, eine Carbonylgruppe, eine Sulfonylgruppe, eine Methylengruppe oder eine Isopropylidengruppe steht, darstellen.

Ist b 1, so bedeuten sowohl $R^{17}$ als auch $R^{18}$ vorzugsweise Alkylengruppen mit 2 bis 6 Kohlenstoffatomen.

$R^{20}$ steht vorzugsweise für eine gegebenenfalls durch eine oder mehrere Carbonyloxygruppen oder ein oder mehrere Äthersauerstoffatome unterbrochene Alkylengruppe mit bis zu 9 Kohlenstoffatomen.

Besonders bevorzugt sind solche Harze, die Gruppen der Formel IX enthalten, worin jedes Paar $R^{19}$ eine Gruppe der Formel $-C(R^{21}R^{22})CO-$ bedeutet, wobei $R^{21}$ für eine Methyl-, Äthyl-, n-Propyl-, n-Pentyl-, Neopentyl-, sek.-Amyl-oder 2-Äthylhexylgruppe und $R^{22}$ für eine Methylgruppe stehen oder $R^{21}$ und $R^{22}$ zusammen Pentamethylen oder Hexamethylen darstellen.

Spezielle Beispiele für als $R^{15}$ und $R^{16}$ geeignete Gruppen, wenn diese auch der Formel IX entsprechen, sind

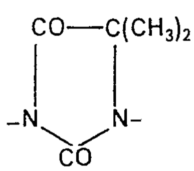

XIII

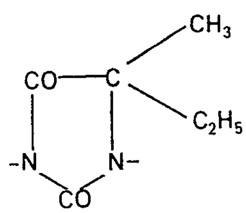

XIV

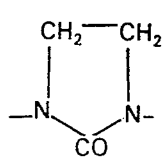

XV

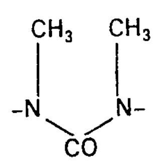

XVI

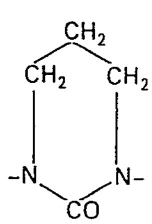

XVII

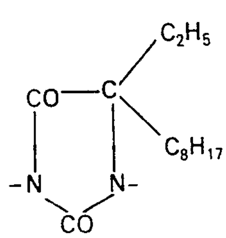

XVIII

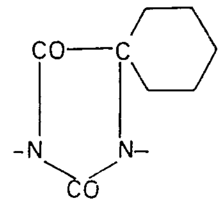

XIX

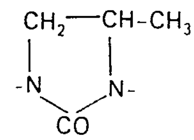

XX

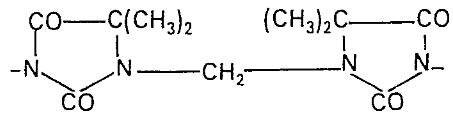

XXI

sowie, falls sie auch der Formel X entsprechen,

$-OOC(CH_2)_gCOO-$ XXII

worin g 2, 3 oder 4 ist.

Die Gruppen der Formeln XIII bis XXI stellen den Rest des 5,5-Dimethylhydantoins, 5-Äthyl-5-methylhydantoins, Imidazolidin-2-ons, 1,3-Dimethylharnstoffs, Hexahydro-2H-pyrimidin-2-ons, 5-Methyl-5-(2-äthylhexyl)-hydantoins, 5,5-Pentamethylenhydantoins, 4-Methylimidazolidin-2-ons bzw. 1,1'-Methylen-bis-(5,5-dimethylhydantoins) dar, während die Gruppen der Formel XXII die Reste der Bernstein-, Glutar- und Adipinsäure sind.

Weitere Beispiele geeigneter Gruppen $R^{15}$ und $R^{16}$, falls diese auch der Formel X entsprechen, sind solche der Formeln

$-O(CH_2)_2O-$ XXIII

$-(CH_2)_4O-$ XXIV

Spezielle Beispiele für geeignete Gruppen $R^{15}$ und $R^{16}$, wenn diese nicht auch der Formel IX oder X entsprechen, sind solche der Formel

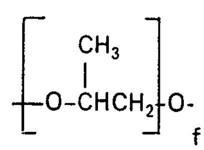

XXV

worin f eine ganze Zahl vom Durchschnittswert 7,3 ist, sowie

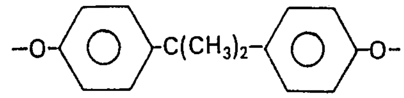

XXVI

Die Gruppen der Formeln XXIII bis XXVI stellen die Reste des Äthylenglykols, Butan-1,4-diols, eines Poly-(oxypropylen)-glykols vom Durchschnittsmolekulargewicht 425 bzw. 2,2-Bis-(4-hydroxyphenyl)-propans dar.

Die Harze der Formel VIII, worin b null ist, lassen sich in zwei Stufen herstellen.

Bei der ersten handelt es sich um die Umsetzung eines Diepoxids der Formel

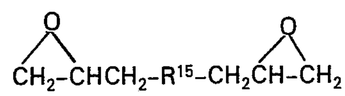

XXVII

mit einem zweiwertigen Alkohol, einem zweiwertigen Phenol, einer Dicarbonsäure oder einem Amid bzw. Amid-Imid der Formel

$$H-R^{16}-H \qquad XXVIII$$

zu einem vorverlängerten, linearen Diepoxid der Formel

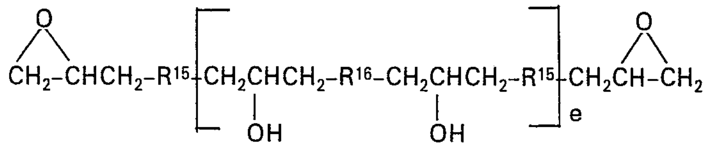

XXIX

worin e, $R^{15}$ und $R^{16}$ die oben angegebenen Bedeutungen haben.

Üblicherweise erhitzt man das Diepoxid der Formel XXVII mit der Verbindung der Formel XXVIII auf eine Temperatur im Bereich 120°–210°C und insbesondere 140–190°C. Die Reaktion lässt sich durch Zusatz geeigneter Katalysatoren beschleunigen. Solche Katalysatoren sind beispielsweise Alkalihydroxyde wie Natriumhydroxyd, Alkalihalogenide wie Lithiumchlorid, Kaliumchlorid und Natriumchlorid, -bromid oder -fluorid, tertiäre Amine wie Triäthylamin, Tri-n-propylamin, N-Benzyldimethylamin, N,N'-Dimethylanilin und Triäthanolamin, quartäre Ammoniumbasen wie Benzyltrimethylammoniumhydroxyd, quartäre Ammoniumsalze wie Tetramethylammoniumchlorid, Tetraäthylammoniumchlorid, Benzyltrimethylammoniumchlorid, Benzyltrimethylammoniumacetat, und Methyltrithylammoniumchlorid, sowie Hydrazine mit einem tertiären Stickstoffatom, wie 1,1-Dimethylhydrazin, das auch in seiner quartärisierten Form eingesetzt werden kann. Je nach der Wahl der Ausgangsstoffe verläuft die Reaktion manchmal quantitativ und so schnell, dass kein Katalysatorzusatz erforderlich ist. Während man im allgemeinen die Ausgangsstoffe bei Raumtemperatur miteinander vermischt und sie dann auf die Reaktionstemperatur bringt, ist es im Fall miteinander sehr reaktionsfähiger Komponenten vorteilhaft, wenn man das Diepoxid der Formel XXVII zunächst allein auf die erforderliche Reaktionstemperatur erhitzt und dann die übrigen reaktiven Komponenten allmählich in kleinen Anteilen dazugibt. Das Fortschreiten der Reaktion bis zur Bildung des Endprodukts mit einem definierten, im wesentlichen konstant bleibenden Epoxidgruppengehalt lässt sich durch Titration der Epoxidgruppen in während der Reaktion gezogenen Proben verfolgen.

Derartige Vorverlängerungsreaktionen sind bekannt (siehe z.B. die oben erwähnte britische Patentschrift Nr. 1 521 933).

In der zweiten Stufe wird aus dem vorverlängerten Diepoxid der Formel XXIX das mit Wasser verdünnbare Harz der Formel VIII durch Öffnung der endständigen Epoxidgruppen durch Umsetzung mit Acrylsäure oder Methacrylsäure erhalten.

Diese Reaktion erfolgt im allgemeinen bei einer Temperatur von 60°C bis 150°C, insbesondere bei 100° bis 130°C, gegebenenfalls in Gegenwart eines inerten polaren Lösungsmittels wie Chloroform. Das Molverhältnis des vorverlängerten Diepoxids der Formel XXIX zu Acrylsäure oder Methacrylsäure hat vorzugsweise einen solchen Wert, dass im wesentlichen sämtliche angegebenen Glycidylgruppen in (Meth)acryloyl-2-hydroxypropylgruppen umgewandelt werden.

Zweckmässig ist dabei ein Katalysator für die Ringöffnungsreaktion vorhanden. Dieser Katalysator kann Natriumacetat oder vorzugsweise ein tertiäres Amin wie eines der oben angeführten, ein quartäres Ammoniumsalz wie eines der oben angeführten oder ein Salz des dreiwertigen Chroms mit einer Alkansäure wie Octansäure und 2-Äthylhexansäure oder einer Alkensäure wie Acrylsäure sein.

Gewünschtenfalls kann man einen Radikalinhibitor wie Hydrochinon oder 2,6-Di-tert.-butyl-4-methylphenol mitverwenden, um dem Auftreten von Nebenreaktionen entgegenzuwirken. Solche Inhibitoren brauchen nach erfolgter Reaktion nicht entfernt zu werden, da sie die Polymerisation des Produkts bei Belichtung mit aktinischer Strahlung nicht verhindern.

Die Harze der Formel VIII, in denen b 1 ist, lassen sich aus den vorverlängerten linearen Diepoxiden der Formel XXIX durch Öffnung der endständigen Epoxidgruppen bei der Umsetzung mit einer Dicarbonsäure der Formel

$$HOOC-R^{17}-COOH \qquad XXX$$

worin $R^{17}$ die oben angegebene Bedeutung hat, oder dem Anhydrid einer Disäure der Formel XXX und nachfolgende Veresterung der so gebildeten endständigen Carbonsäuregruppen mit einem hydroxylgruppenhaltigen Ester der Acryl- oder Methacrylsäure der Formel

$CH_2 = CCOO-R^{18}OH$ XXXI
|
$R^{14}$

worin $R^{14}$ und $R^{18}$ die oben angegebenen Bedeutungen haben, herstellen.

Die Ringöffnung der Epoxidgruppen erfolgt im allgemeinen unter denselben Bedingungen wie oben für die Ringöffnung der Diepoxide der Formel XXIX mit Acryl- oder Methacrylsäure beschrieben, d.h. bei einer Temperatur von 60–150°C in Gegenwart eines Katalysators und gegebenenfalls eines Radikalinhibitors.

Die Veresterung mit einem Hydroxyester der Formel XXXI kann man unter üblichen Veresterungsbedingungen, insbesondere durch Erhitzen bei 60° bis 150°C, speziell bei 100° bis 130°C, gegebenenfalls in einem inerten, vorzugsweise mit Wasser nicht mischbaren Lösungsmittel sowie gegebenenfalls in Gegenwart eines wasserentziehenden Mittels durchführen. Gewünschtenfalls lassen sich diese beiden Stufen als eine einzige Reaktion durchführen, indem man die Reaktionspartner in einem einzigen Gefäss vermischt und erhitzt.

Zu den zur Verwendung als Komponente (b) beim erfindungsgemässen Verfahren geeigneten Epoxidharzen zählen die Diglycidyläther mehrwertiger Phenole wie Bisphenol A (2,2-Bis-(4-hydroxyphenyl)-propan) und Tetrabrombisphenol A (2,2-Bis-(3,5-dibrom-4-hydroxyphenyl)-propan) sowie durch Vorverlängerung dieser Diglycidyläther erhaltene Epoxidharze. Der Einsatz von wasserlöslichen N,N-Diglycidylverbindungen, insbesondere N,N'-Diglycidylhydantoinen, als die Epoxidharzkomponente wird besonders bevorzugt.

Die cellulosehaltigen Fasern können lose, als gewebtes Flächengebilde oder als Faservlies vorliegen und bestehen vorzugsweise aus Baumwolle oder Papier.

Das Gewichtsverhältnis der Komponente (a), d.h. des Harzes der Formel VIII, zu Komponente (b), d.h. dem Epoxidharz, kann in weiten Grenzen schwanken, liegt aber vorzugsweise im Bereich 1:0,5–4.

Die Fasern können auf übliche Weise imprägniert werden. Im allgemeinen hat der Wasseranteil keine entscheidende Bedeutung, doch sollte dieser beispielsweise auf etwa 2 bis 30 Gew.%, berechnet auf die wässrige Zusammensetzung, beschränkt werden, um die Notwendigkeit einer Trocknung zu vermeiden. Die Aufnahme der Zusammensetzung beträgt üblicherweise 50 bis 300 Gew.%, vorzugsweise 50 bis 150 Gew.%, berechnet auf das Fasergewicht.

Das Imprägniergemisch kann ferner übliche Zusätze wie Flammhemmstoffe enthalten.

Bei dem erfindungsgemässen Verfahren wird vorzugsweise aktinische Strahlung einer Wellenlänge von 200 bis 600 nm eingesetzt.

Wie schon angegeben werden die imprägnierten Fasern vorzugsweise in Gegenwart eines Photosensibilisators mit aktinischer Strahlung belichtet. Zweckmässig wird der Photosensibilisator in der Imprägnierzusammensetzung eingebracht. Als Sensibilisatoren eignen sich unter anderem Chinone, Diphenylcarbinole, 5-Nitroacenaphten, 2-substituierte Thioxanthone, Diphenylmethane und α-Halogenoacetophenone wie p-tert.-Butylphenyl-trichlormethylketon, Photoredoxkatalysatoren wie ein Gemisch aus einem Phenothiazinfarbstoff (z.B. Methylenblau) oder einem substituierten Chinoxalin mit einem Elektronendonator (wie einer Sulfinsäure oder deren Salz, einem Phosphin, Arsin oder Thioharnstoff), Benzophenone, Benzildialkylketale wie Benzildimethylketal (d.h. α-Methoxybenzoinmethyläther), Benzoine, Benzoinalkyläther sowie O-Alkoxycarbonylderivate eines Oxims des Benzils oder 1-Phenylpropan-1,2-dions wie Benzil-(O-äthoxycarbonyl)-α-monoxim und 1-Phenylpropan-1,2-dion-2-(O-äthoxycarbonyl)-oxim. Bevorzugte Sensibilisatoren sind Michlers Keton (d.h. 4,4'-Bis-(dimethylamino)-benzophenon), Benzoin-n-butyläther sowie Gemische dieser beiden, mit einem Metallsalz der Toluol-p-sulfinsäure vermischte Metallsalze der 2-(m- oder p-Methoxyphenyl)-chinoxalin-6'- oder -7'-sulfonsäure, 1-Phenylpropan-1,2-dion-2-(O-äthoxycarbonyl)-oxim, Benzildimethylketal sowie Gemische dieser beiden, und 2-Chlorthioxanthon und dessen Gemische mit Benzildimethylketal. Üblicherweise werden 0,1 bis 20 und vorzugsweise 0,5 bis 15 Gew.% Sensibilisator eingesetzt, berechnet auf das Gewicht der Komponente (a).

Als aktinische Strahlungsquellen eignen sich unter anderem Kohlelichtbögen, Quecksilberdampflichtbögen, Fluoreszenzlampen mit ultraviolettes Licht ausstrahlenden Leuchtstoffen, Argon- und Xenonglimmlampen, Wolframlampen und photographische Flutlampen. Darunter sind Quecksilberdampflichtbögen, insbesondere Höhensonnen, fluoreszierende Höhensonnen und Metallhalogenidlampen am besten geeignet. Die zur Belichtung der imprägnierten Fasern erforderliche Zeit hängt von verschiedenen Faktoren ab, unter anderem beispielsweise der jeweils verwendeten Komponente (a), der Art der Lichtquelle und deren Abstand von den Fasern, und lässt sich leicht durch Serienversuche ermitteln.

Gegenstand der Erfindung ist ferner ein Verfahren zur Herstellung eines Verbundstoffartikels, welches dadurch gekennzeichnet ist, dass man einen nach dem erfindungsgemässen Verfahren hergestellten Prepreg heisshärtet.

Wie ebenfalls schon angegeben, werden die cellulosehaltigen Fasern vorzugsweise auch mit einer heisshärtenden Menge eines latenten Heisshärters für das Epoxidharz (b) imprägniert. Solche Mittel sind wohlbekannt und umfassen Dicyandiamid (allein oder als Gemisch mit einem N,N-Dimethyl-N'-arylharnstoff wie Bis-(N,N-dimethylureido)-toluol oder N,N-Dimethyl-N'-(4-chlorphenyl)-harnstoff), Imidazole sowie Aminkomplexe des Bortrichlorids oder Bortrifluorids. Zweckmässig werden diese Mittel in die (a) und (b) enthaltende wässrige Zusammensetzung eingearbeitet.

Der Fachmann in der Epoxidharztechnik kann die geeigneten, bei der Bildung des heissgehärteten Verbundstoffs, der im allgemeinen in Form eines laminierten Schichtkörpers vorliegt, anzuwendenden Hitze- und Druckbedingungen leicht nach üblichen Methoden bestimmen.

Die nachfolgenden Beispiele dienen der Erläuterung der Erfindung.

Die in den Beispielen verwendeten Epoxidharze und photopolymerisierbaren Harze werden wie folgt hergestellt. Die Epoxidgehalte werden durch Titration mit 0,1 n-Überchlorsäurelösung in Eisessig in Gegenwart überschüssigen Tetraäthylammoniumbromids mit Kristallviolett als Indikator bestimmt. Teile und Prozentangaben sind stets Gewichtsteile und Gewichtsprozente.

Epoxidharz A

Man rührt N,N'-Diglycidyl-5,5'-dimethylhydantoin (Epoxidgehalt 8,04 val/kg, 100 g), Bisphenol-A-diglycidyläther (Epoxidgehalt 5,30 val/kg, 100 g), 1,4-Butandiol (37,2 g) und N-Phenylimidazol (0,2 g) 5 Stunden bei 120°C. Man gibt einen weiteren Anteil 2-Phenylimidazol (0,2 g) dazu und erhitzt noch weitere 5 Stunden bei 120°C und dann 6½ Stunden bei 140°C, wonach der Epoxidgehalt des Gemischs 2,44 val/kg ist.

Epoxidharz B

Man rührt N,N'-Diglycidyl-5,5-dimethylhydantoin (Epoxidgehalt 8,04 val/kg, 100 g), den Diglycidyläther eines Polyoxypropylenglykols vom Durchschnittsmolekulargewicht 425 (Epoxidgehalt 3,07 val/kg, 200 g), Bisphenol-A-diglycidyläther (Epoxidgehalt 5,30 val/kg, 100 g), Bisphenol-A (100 g) und N-Phenylimidazol (0,4 g) 3½ Stunden bei 120°C, wonach der Epoxidgehalt des Gemischs 2,67 val/kg beträgt.

Epoxidharz C

Man rührt N,N'-Diglycidyl-5,5-pentamethylenhydantoin (Epoxidgehalt 6,23 val/kg, 200 g), 1,4-Butandiol (36 g) und N-Phenylimidazol (0,4 g) 12¼ Stunden bei 140°C und dann 3¾ Stunden bei 160°C, wonach der Epoxidgehalt auf 2,35 val/kg gefallen ist.

Epoxidharz D

Man gibt Adipinsäure (73 g) portionsweise unter Rühren zu N-Phenylimidazol (0,4 g) enthaltendem N,N'-Diglycidyl-5,5-dimethylhydantoin (Epoxidgehalt 8,04 val/kg, 200 g), wobei man die Temperatur auf 100°C hält und die Zugabe im Verlauf von 40 Minuten durchführt. Man erhitzt nach 4⅓ Stunden weiter bei 100°C, wonach der Epoxidgehalt auf 2,35 val/kg gefallen ist.

Photopolymerisierbares Harz I

Man gibt 5,5-Dimethylhydantoin (77,4 g) portionsweise unter Rühren zu einem Gemisch aus 1,4-Butandiol-diglycidyläther (Epoxidgehalt 8,6 val/kg, 200 g), der Tetramethylammoniumchlorid (0,25 g) als Vorverlängerungskatalysator enthält. Das Gemisch wird auf 120°C erhitzt, wobei eine exotherme Reaktion einsetzt, welche die Temperatur auf 230°C steigert. Dann kühlt man auf 100°C ab; der Epoxidgehalt ist nun 2,2 val/kg. Man setzt 2,6-Di-t-butyl-4-methylphenol (0,44 g) als Polymerisationsinhibitor und danach im Verlauf einer Stunde Methacrylsäure (54,6 g) und 2,6-Di-t-butyl-4-methylphenol (0,88 g) dazu. Das Gemisch wird 3½ Stunden auf 100°C erhitzt, wonach sein Epoxidgehalt auf einen geringen Wert (0,6 val/kg) gefallen ist.

Dieses Produkt entspricht im wesentlichen der Formel VIII, worin b null ist und $R^{14}$ jeweils für eine Methylgruppe, $R^{15}$ jeweils für eine Gruppe der Formel XXIV und $R^{16}$ jeweils für eine Gruppe der Formel XIII stehen.

Photopolymerisierbares Harz II

Man erhitzt N,N'-Diglycidyl-5,5-dimethylhydantoin (Epoxidgehalt 7,88 val/kg, 50 g), das als Katalysator für die nachfolgende Reaktion mit Acrylsäure 2 Tropfen einer 5%igen Lösung von Chrom-III-trisoctanoat in Petroläther enthält, auf 100°C und gibt Adipinsäure (14 g) im Verlauf von 1 Stunde dazu. Nach vollendeter Zugabe erhitzt man weitere 1¾ Stunden auf 100°C, wonach der Epoxidgehalt 3,96 val/kg ist. Im Verlauf von 30 Minuten setzt man dem Harz bei 100°C Acrylsäure (8,1 g) zu, die 0,1 g 2,6-Di-t-butyl-4-methyl-phenol und weitere 2 Tropfen der Chrom-III-trisoctanoatlösung enthält, und erhitzt weitere 6½ Stunden bei 100°C. Der Epoxidgehalt des Produkts ist 0,46 val/kg.

Dieses Produkt entspricht im wesentlichen der Formel VIII, worin b null ist und $R^{14}$ jeweils für ein Wasserstoffatom, $R^{15}$ jeweils für eine Gruppe der Formel XIII und $R^{16}$ jeweils für eine Gruppe der Formel XXII mit g = 4 stehen.

Photopolymerisierbares Harz III

Man gibt eine Acrylsäure (20,8 g), 2,6-Di-t-butyl-4-methylphenol (0,2 g) und eine 5%ige Lösung von Chrom-III-trisoctanoat in Petroläther (0,1 g) enthaltende Lösung im Verlauf von ½ Stunde unter Rühren bei 100°C zu Epoxidharz A (118,6 g). Nach vollendeter Zugabe erhitzt man weitere 5½ Stunden auf 100°C, wonach der Epoxidgehalt auf einen vernachlässigbar kleinen Wert (0,07 val/kg) gefallen ist. Dann wird Wasser (23,1 g) dazugegeben.

Das Produkt entspricht im wesentlichen der Formel VIII, worin b null ist, einige der Gruppen $R^{15}$ der Formel XIII und der Rest der Formel XXVI entsprechen, die Gruppen $R^{16}$ Oxybutylenoxygruppen sind und $R^{14}$ ein Wasserstoffatom bedeutet.

Photopolymerisierbares Harz IV

Man gibt eine Acrylsäure (50,3 g), 2,6-Di-t-butyl-4-methylphenol (0,6 g) und eine 5%ige Lösung von Chrom-III-trisoctanoat in Petroläther (0,3 g) enthaltende Lösung im Verlauf von ½ Stunde unter Rühren bei 100°C zu Epoxidharz B (261,5 g). Man erhitzt noch weitere 4½ Stunden bei 100°C, wonach der Epoxidgehalt auf einen vernachlässigbar kleinen Wert (0,08 val/kg) gefallen ist.

Das Produkt entspricht im wesentlichen der Formel VIII, worin b null ist, einige der Gruppen $R^{15}$ der Formel XIII, einige der Formel XXV und der Rest der Formel XXVI und die Gruppen $R^{16}$ ebenfalls der Formel XXVI entsprechen sowie $R^{14}$ ein Wasserstoffatom bedeutet.

Photopolymerisierbares Harz V

Man rührt Epoxidharz C (118 g) bei 100°C und gibt eine Methacrylsäure (23,8 g), 2,6-Di-t-butyl-4-methylphenol (0,4 g) und eine 5%ige Lösung von Chrom-III-trisoctanoat in Petroläther (0,1 g) enthaltende Lösung im Verlauf von ½ Stunde dazu. Man erhitzt noch weitere 4⅓ Stunden bei 100°C, wonach der Epoxidgehalt auf einen vernachlässigbaren Wert (0,28 val/kg) gefallen ist. Dann wird Wasser (45 g) dazugegeben.

Das Produkt entspricht im wesentlichen der

Formel VIII, worin b null ist, $R^{14}$ jeweils für eine Methylgruppe, $R^{15}$ jeweils für eine Gruppe der Formel XIX und $R^{16}$ jeweils für eine Gruppe der Formel XXIV stehen.

Photopolymerisierbares Harz VI

Man rührt Epoxidharz D (273 g) bei 100°C und gibt eine Acrylsäure (46,2 g), 2,6-Di-t-butyl-4-methylphenol (0,6 g) und eine 5%ige Lösung von Chrom-III-trisoctanoat in Petroläther (0,3 g) enthaltende Lösung im Verlauf von ½ Stunde dazu. Man erhitzt noch weitere 2 Stunden, wonach der Epoxidgehalt auf einen vernachlässigbaren Wert (0,34 val/kg) gefallen ist. Dann wird Wasser (30 g) dazugegeben.

Das Produkt entspricht im wesentlichen der Formel VIII, worin b null ist, $R^{14}$ jeweils für ein Wasserstoffatom, $R^{15}$ für eine Gruppe der Formel XIII und $R^{16}$ jeweils für eine Gruppe der Formel XXII stehen.

Photopolymerisierbares Harz VII

Man versetzt Tetramethylammoniumchlorid (0,1 g) enthaltendes und auf 100°C erhitztes Diglycidylhexahydrophthalat (Epoxidgehalt 6,4 val/kg, 41,2 g) portionsweise im Verlauf von 1 Stunde mit 5,5-Dimethylhydantoin (10,2 g). Anschliessend rührt man 4 Stunden bei 100°C, wonach der Epoxidgehalt auf 2,45 val/kg gefallen ist.

In einem getrennten Gefäss rührt man Bernsteinsäureanhydrid (30 g), 2-Hydroxyäthylacrylat (34,2 g), Tetramethylammoniumchlorid (0,2 g) und 2,6-Di-t-butyl-4-methyl-phenol (0,15 g) 3 Stunden bei 90°C und kühlt dann ab. Das Produkt, d.h. 3-(2-(Acryloyloxy)-äthoxycarbonyl)-propionsäure (27,2 g) wird dann mit 2,6-Di-t-butyl-4-methylphenol (0,1 g) vermischt und im Verlauf einer Stunde bei 100°C zu dem vorverlängerten Harz gegeben; das Gemisch wird noch 4½ Stunden bei 100°C gerührt, wonach sein Epoxidgehalt vernachlässigbar ist. Das Produkt wird mit 33% Wasser verdünnt.

Das Produkt entspricht im wesentlichen der Formel VIII, worin b 1 ist, $R^{17}$ und $R^{18}$ je für $-CH_2CH_2-$, $R^{14}$ für ein Wasserstoffatom, $R^{15}$ für Hexahydrophthaloyl und $R^{16}$ für eine Gruppe der Formel XIII stehen.

Beispiel 1

Man vermischt photopolymerisierbares Harz I (10 Teile) mit 40 Teilen eines Epoxidharzes, nämlich N,N'-Di-glycidyl-5,5-dimethylhydantoin (Epoxidgehalt 7,88 val/kg), 2 Teilen Wasser, 0,5 Teilen Benzildimethylketal und 1 Teil Bortrichlorid/Trimethylaminkomplex.

Die erhaltene klare Lösung wird zum Imprägnieren von Kraftpapier von Elektroqualität mit einem Flächengewicht von 60 g/m² verwendet, wobei die Aufnahme 100%, berechnet auf das Gewicht des Papiers, beträgt. Das imprägnierte Papier wird 30 Sekunden beidseitig mit einer 80 W/cm-Mitteldruckquecksilberlampe in 25 cm Abstand bestrahlt, was einen etwas klebrigen Prepreg ergibt. Vier Schichten davon werden übereinander angeordnet, in einer Presse 1 Stunde bei 120°C unter 7 MPa Druck heissgehärtet und dann durch 2 Stunden Erhitzen bei 140°C nachgehärtet. Der Schichtkörper ist hart und steif und wird durch die in der britischen Norm Nr. 5102:1974, Anhang R, angegebene Durchstichprüfung nicht beschädigt.

Beispiel 2

Man vermischt photopolymerisierbares Harz I (15 Teile) mit je 20 Teilen der beiden Epoxidharze N,N'-Diglycidyl-5,5-dimethylhydantoin (Epoxidgehalt 7,88 val/kg) und mit Tetrabrombisphenol A auf einen Epoxidgehalt von 2,0 val/kg vorverlängertes N,N'-Diglycidyl-5-dimethylhydantoin, 2,0 Teilen Wasser, 0,5 Teilen 2-Chlorthioxanthon, 2,0 Teilen Dicyandiamid und 0,5 Teilen N-(4-Chlorphenyl)-N,N'-dimetyhlharnstoff.

Dieses Gemisch wird zum Imprägnieren von Kraftpapier wie in Beispiel 1 beschrieben verwendet und 10 Sekunden beidseitig mit einer 80 W/cm-Mitteldruckquecksilberlampe im Abstand von 25 cm bestrahlt, was einen etwas klebrigen Prepreg ergibt. Vier Schichten davon werden übereinander angeordnet und in einer Presse bei 120°C 1 Stunde unter 7 MPa Druck heissgehärtet. Der entstandene, gehärtete Schichtkörper ist hart und steif und wird durch die oben angegebene Durchstichprüfung nicht beschädigt.

Beispiel 3

Man vermischt photopolymerisierbares Harz II (20 Teile) mit 20 Teilen eines Epoxidharzes, d.h. N,N'-Diglycidyl-5,5-dimethylhydantoin, 10 Teilen Wasser, je 0,2 Teilen Benzildimethylketal und 1-Phenyl-1,2-propandion-2-(O-äthoxycarbonyl)-oxim, 2,6 Teilen eines Gemischs aus 2,4- und 2,6-Bis-(N,N-dimethylureido)-toluol sowie 0,65 Teilen Dicyandiamid. Beim Erwärmen des Gemischs auf 60°C bildet sich eine klare Lösung. Mit dieser wird Kraftpapier vom Gewicht 350 g/m² imprägniert, wobei die Aufnahme 100%, berechnet auf das Gewicht des Papiers, beträgt. Das imprägnierte Papier wird beidseitig 5 Sekunden mit der in Beispiel 1 verwendeten Lampe bestrahlt, wobei man einen klebfreien Prepreg erhält. Vier Schichten des Prepregs werden übereinander angeordnet und dann 5 Minuten bei 120°C nur unter Nenndruck und anschliessend bei 120°C weiter erhitzt, während der Schichtkörper für 3 Gänge von je 2 Minuten mit 7 MPa gepresst wird, wobei man den Druck jeweils 30 Sekunden zwischen den Gängen entspannt. Schliesslich wird der Schichtkörper 1 Stunde unter 7 MPa Druck erhitzt, wobei man ein gut verfestigtes Produkt erhält, in dem sich Löcher leicht ohne Verformung stanzen lassen; der Harzgehalt beträgt 41%.

Beispiel 4

Man vermischt photopolymerisierbares Harz VII (60 Teile) mit 45 Teilen Epoxidharz C, 5 Teilen Wasser, 0,6 Teilen Benzildimethylketal und 2 Teilen Bortrichlorid/Octyldimethylaminkomplex.

Die erhaltene klare Lösung wird zum Imprägnieren von Kraftpapier von Elektroqualität mit einem Flächengewicht von 75 g/m² verwendet,

wobei die Aufnahme 100%, berechnet auf das Gewicht des Papiers, beträgt. Das imprägnierte Papier wird 3 Sekunden beidseitig mit einer 80 W/cm-Mitteldruckquecksilberlampe in 25 cm Abstand bestrahlt, was einen klebfreien Prepreg ergibt. Sechs Schichten davon werden übereinander angeordnet und in einer Presse bei 120°C 1 Stunde unter 7 MPa Druck erhitzt. Der entstandene Schichtkörper ist hart und steif und wird durch die oben angegebene Durchstichprüfung nicht beschädigt.

Beispiel 5

Man vermischt photopolymerisierbares Harz III (50 Teile) mit 25 Teilen Epoxidharz A, 5 Teilen Wasser, 0,5 Teilen Benzildimethylketal und 1 Teil Bortrifluorid/Monoäthylaminkomplex.

Die erhaltene klare Lösung wird zum Imprägnieren von Kraftpapier von Elektroqualität mit einem Flächengewicht von 75 g/m² verwendet, wobei die Aufnahme 150%, berechnet auf das Gewicht des Papiers, beträgt. Das imprägnierte Papier wird 5 Sekunden beidseitig mit einer 80 W/cm-Mitteldruckquecksilberlampe in 25 cm Abstand bestrahlt, was einen klebfreien Prepreg ergibt. Acht Schichten davon werden übereinander angeordnet und in einer Presse bei 120°C 1 Stunde unter 7 MPa Druck heissgehärtet. Der entstandene Schichtkörper ist gut verfestigt und wird durch die oben angegebene Durchstichprüfung nicht beschädigt.

Beispiel 6

Man vermischt photopolymerisierbares Harz IV (40 Teile) mit 25 Teilen Epoxidharz B, 5 Teilen Wasser, 0,5 Teilen Benzildimethylketal und 0,5 Teilen N-Phenylimidazol.

Die erhaltene klare Lösung wird zum Imprägnieren von Kraftpapier von Elektroqualität mit einem Flächengewicht von 75 g/m² verwendet, wobei die Aufnahme 200%, berechnet auf das Gewicht des Papiers, beträgt. Das imprägnierte Papier wird 8 Sekunden beidseitig mit einer 80 W/cm-Mitteldruckquecksilberlampe in 25 cm Abstand bestrahlt, was einen etwas klebrigen Prepreg ergibt. Sechs Schichten davon werden übereinander angeordnet und in einer Presse 1 Stunde bei 120°C unter 7 MPa Druck heissgehärtet. Der entstandene Schichtkörper ist hart und steif und wird durch die oben angegebene Durchstichprüfung nicht beschädigt.

Beispiel 7

Man vermischt photopolymerisierbares Harz V (30 Teile) mit 25 Teilen Epoxidharz B, 0,3 Teilen Benzildimethylketal und 0,3 Teilen Bortrichlorid/Trimethylaminkomplex.

Man erwärmt das Gemisch auf 60°C, um eine klare Lösung zu erhalten, die dazu verwendet wird, ein gewebtes Baumwolltuch mit einem Flächengewicht von 120 g/m² zu imprägnieren, wobei die Aufnahme 275%, berechnet auf das Gewicht der Baumwolle, beträgt. Die imprägnierte Baumwolle wird 2 Sekunden beidseitig mit einer 80 W/cm-Mitteldruckquecksilberlampe in 25 cm Abstand bestrahlt, was einen klebfreien Prepreg ergibt. Sechs Schichten davon werden übereinander angeordnet und in einer Presse 1 Stunde bei 120°C unter 7 MPa Druck heissgehärtet. Der entstandene Schichtkörper ist hart und biegsam und wird durch die oben angegebene Durchstichprüfung nicht beschädigt.

Beispiel 8

Man vermischt photopolymerisierbares Harz VI (30 Teile) mit 25 Teilen Epoxidharz B, 5 Teilen Wasser, 0,5 Teilen Benzildimethylketal und 0,5 Teilen Bortrichlorid/Trimethylaminkomplex.

Die erhaltene klare Lösung wird zum Imprägnieren eines gewebten Baumwolltuches mit einem Flächengewicht von 120 g/m² verwendet, wobei die Aufnahme 50%, berechnet auf das Gewicht der Baumwolle, beträgt. Die imprägnierte Baumwolle wird 5 Sekunden beidseitig mit einer 80 W/cm-Mitteldruckquecksilberlampe in 25 cm Abstand bestrahlt, was einen klebfreien Prepreg ergibt. Vier Schichten davon werden übereinander angeordnet und in einer Presse 1 Stunde bei 120°C unter 7 MPa Druck heissgehärtet. Der entstandene Schichtkörper ist hart und biegsam und wird durch die oben angegebene Durchstichprüfung nicht beschädigt.

**Patentansprüche**

1. Verfahren zur Herstellung von Prepregs, dadurch gekennzeichnet, dass man cellulosehaltige Fasern mit einer wässrigen Zusammensetzung imprägniert, die aus (a) einem photopolymerisierbaren Harz und (b) einem Epoxidharz besteht, und dann die imprägnierten Fasern mit aktinischer Strahlung belichtet, so dass (a) photopolymerisiert wird, wobei (a) der Formel

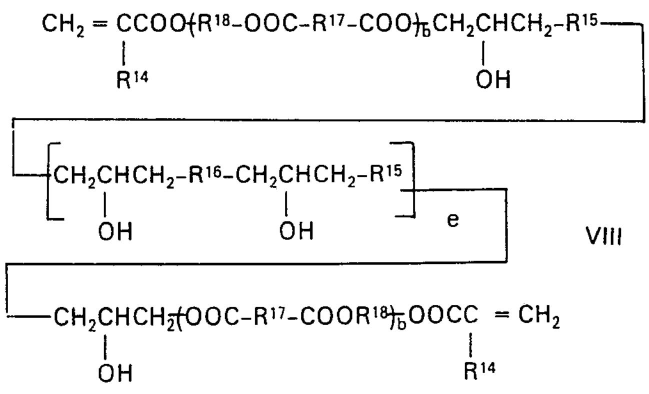

VIII

entspricht, worin b null oder 1 und e eine ganze Zahl von mindestens 1 ist, $R^{14}$ jeweils für ein Wasserstoffatom oder eine Methylgruppe, $R^{15}$ jeweils für den zweiwertigen Rest einer Verbindung mit zwei direkt an ein Sauerstoff-, Stickstoff- oder Schwefelatom bzw. -atome gebundenen Glycidylgruppen nach Wegnahme dieser beiden Glycidylgruppen, $R^{16}$ jeweils für den zweiwertigen Rest eines zweiwertigen Alkohols, eines zweiwertigen Phenols, einer Dicarbonsäure oder einer zwei unter Amid- und Imidgruppen ausgewählte Gruppen enthaltenden Verbindung nach Wegnahme von zwei endständigen, an ein Sauerstoff- oder Stickstoffatom bzw. -atome gebundenen Wasserstoffatomen, $R^{17}$ jeweils für eine Alkylengruppe mit 1 bis 6 Kohlenstoffatomen, eine Alkenylengruppe mit 2 bis 10 Kohlenstoffatomen, eine Arylengruppe mit 6 bis 10 Kohlenstoffatomen oder eine Cycloalkylen- oder Cycloalkenylengruppe mit 5 bis 8 Kohlenstoffatomen und $R^{18}$ jeweils für eine zweiwertige aliphatische, cycloaliphatische oder araliphatische Gruppe mit 2 bis 8 Kohlenstoffatomen stehen, mit der Massgabe, dass mindestens 25% der Summe der (e + 1) $R^{15}$- und e $R^{16}$-Gruppen je eine Gruppe der Formel

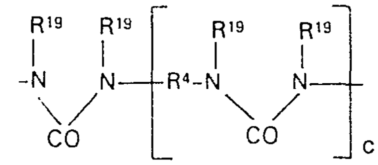

IX

oder eine Gruppe der Formel

$-O(OC)_d-R^{20}-(CO)_d-O-$ X

darstellen, worin $R^4$ für einen zweiwertigen aliphatischen, cycloaliphatischen oder araliphatischen Rest mit 1 bis 8 Kohlenstoffatomen steht, $R^{19}$ jeweils eine Alkylgruppe mit 1 bis 4 Kohlenstoffatomen bzw. Paare $R^{19}$ zusammen eine Gruppe der Formel

$-CH_2CH_2-$, $-C(R^{21}R^{22})CO-$, $-CH_2CH-$,
$CH_3$

$-CH_2CH_2CH_2-$ oder $-COCO-$ bedeuten, c und d je null oder 1 sind, $R^{20}$ eine geradkettige oder verzweigte aliphatische Gruppe mit 2 bis 20 Kohlenstoffatomen oder, falls alle d 1 sind, gegebenenfalls auch eine Gruppe der Formel

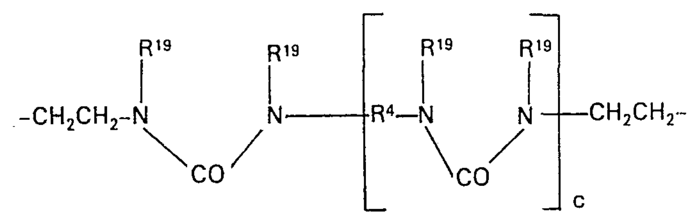

XI

darstellt sowie $R^{21}$ und $R^{22}$ entweder je für ein Wasserstoffatom oder eine geradkettige oder verzweigte Alkylgruppe mit bis zu 9 Kohlenstoffatomen oder zusammen für eine Tetramethylen-, Pentamethylen-, Methylpentamethylen- oder Hexamethylengruppe stehen.

2. Verfahren nach Anspruch 1, dadurch gekennzeichnet, dass e eine ganze Zahl von 1 bis 10 ist.

3. Verfahren nach Anspruch 1, dadurch gekennzeichnet, dass $R^{20}$ für eine gegebenenfalls durch eine oder mehrere Carbonyloxygruppen oder ein oder mehrere Äthersauerstoffatome unterbrochene Alkylengruppe mit bis zu 9 Kohlenstoffatomen steht.

4. Verfahren nach Anspruch 1, dadurch gekennzeichnet, dass höchstens 75% der Summe der (e+1) $R^{15}$- und e $R^{16}$-Gruppen für eine Gruppe der Formel IX oder eine Gruppe der Formel X mit d = 1 sowie mindestens 25% der $R^{15}$- und $R^{16}$-Gruppen für eine (gegebenenfalls in der Kette durch ein oder mehrere Äthersauerstoffatome unterbrochene) Oxyalkylenoxygruppe mit 2 bis 40 Kohlenstoffatomen oder für eine Oxyarylenoxygruppe mit 6 bis 18 Kohlenstoffatomen stehen.

5. Verfahren nach Anspruch 4, dadurch gekennzeichnet, dass die Alkylenkomponente dieser Oxyalkylenoxygruppe eine Kette von 3 bis 6 aufeinanderfolgenden Kohlenstoffatomen oder eine durch ein oder mehrere Äthersauerstoffatome unterbrochene Kette von 4 bis 28 Kohlenstoffatomen enthält und die Oxyarylenoxygruppe entweder eine Oxyphenylenoxygruppe oder eine Gruppe der Formel

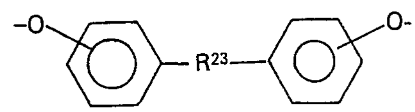

ist, worin $R^{23}$ für eine Kohlenstoff-Kohlenstoffbindung, ein Äthersauerstoffatom, eine Carbonylgruppe, eine Sulfonylgruppe, eine Methylengruppe oder eine Isopropylidengruppe steht.

6. Verfahren nach Anspruch 1, dadurch gekennzeichnet, dass ein Paar $R^{19}$ jeweils für eine Gruppe der Formel $-C(R^{21}R^{22})CO-$ steht, worin $R^{21}$ eine Methyl-, Äthyl-, n-Propyl-, n-Pentyl-, Neopentyl-, sek.-Amyl- oder 2-Äthylhexylgruppe und $R^{22}$ eine Methylgruppe bedeuten oder $R^{21}$ und $R^{22}$ zusammen Pentamethylen oder Hexamethylen darstellen.

7. Verfahren nach Anspruch 1, dadurch gekennzeichnet, dass als (b) ein Diglycidyläther eines mehrwertigen Phenols, ein Vorverlängerungsprodukt eines solchen Diglycidyläthers oder eine wasserlösliche N,N-Diglycidylverbindung vorliegt.

8. Verfahren nach Anspruch 1, dadurch gekennzeichnet, dass die cellulosehaltigen Fasern ferner mit einer heisshärtenden Menge eines Heisshärters für (b) imprägniert werden.

9. Verfahren nach Anspruch 1, dadurch gekennzeichnet, dass die wässrige Zusammensetzung 2 bis 30 Gew.-% Wasser enthält.

10. Verfahren zur Herstellung eines Verbundstoffartikels, dadurch gekennzeichnet, dass man einen nach dem Verfahren gemäss Anspruch 1 hergestellten Prepreg heisshärtet.

**Claims**

1. A method of producing prepregs in which cellulosic fibres are impregnated with a waterborne composition comprising

a) a photopolymerisable resin
b) an epoxide resin,

and then the impregnated fibres are exposed to actinic radiation so that (a) becomes photopolymerised, (a) being of formula

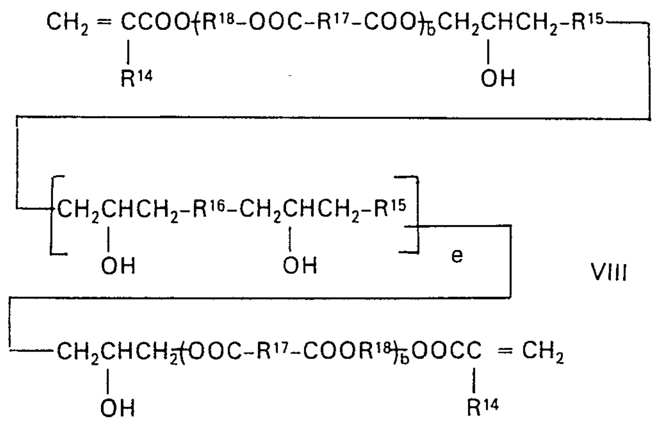

VIII

wherein
b is zero or 1, e is an integer of at least 1, each $R^{14}$ is a hydrogen atom or a methyl group, each $R^{15}$ is the divalent residue of a compound having two glycidyl groups directly attached to an atom or atoms of oxygen, nitrogen, or sulphur, after removal of the said two glycidyl groups, each $R^{16}$ is the divalent residue of a dihydric alcohol, a dihydric phenol, a dicarboxylic acid, or a compound containing two groups selected from amide groups and imide groups, after removal of two terminal hydrogen atoms attached to an atom or atoms of oxygen or nitrogen, each $R^{17}$ is an alkylene group of 1 to 6 carbon atoms, an alkenylene group of 2 to 10 carbon atoms, an arylene group of 6 to 10 carbon atoms, or a cycloalkylene or cycloalkenylene group of 5 to 8 carbon atoms, and each $R^{18}$ is a divalent aliphatic, cycloaliphatic, or araliphatic group of 2 to 8 carbon atoms, with the proviso that at least 25% of the total of the (e+1) $R^{15}$ and e $R^{16}$ groups are each a group of the formula

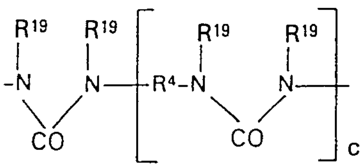

IX

or a group of formula

$$-O(OC)_d-R^{20}-(CO)_d-O- \qquad X$$

wherein
$R^4$ is a divalent aliphatic, cycloaliphatic, or araliphatic radical of 1 to 8 carbon atoms, each $R^{19}$ is an alkyl group of 1 to 4 carbon atoms or each pair of $R^{19}$ conjointly is a group of formula

$-CH_2CH_2-$, $-C(R^{21}R^{22})CO-$, 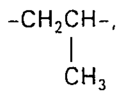

$-CH^2CH^2CH^2-$, or $-COCO-$, each of c and d is zero or 1, $R^{20}$ is a straight or branched chain aliphatic group of 2 to 20 atoms or, provided each d is 1, it may also be a group of formula

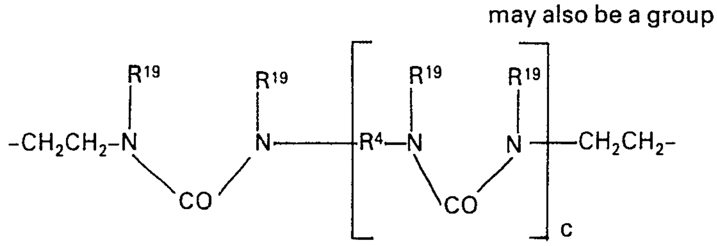

XI

and
$R^{21}$ and $R^{22}$ are either each a hydrogen atom or a straight or branched alkyl group of up to 9 carbon atoms or together they are a tetramethylene, pentamethylene, methylpentamethylene, or hexamethylene group.

2. A method according to claim 1, in which e is an integer from 1 to 10.

3. A method according to claim 1, in which $R^{20}$ is an alkylene group, which may be interrupted by one or more carbonyloxy groups or by one or

more ether oxygen atoms, of up to 9 carbon atoms.

4. A method according to claim 1, in which at most 75% of the total of the (e+1) $R^{15}$ and e $R^{16}$ groups are a group of formula IX or a group of formula X, wherein d is 1, and at least 25% of the $R^{15}$ and $R^{16}$ groups are an oxyalkyleneoxy group of 2 to 40 carbon atoms (which may be interrupted in the chain by one or more ether oxygen atoms) or an oxyaryleneoxy group of 6 to 18 carbon atoms.

5. A method according to claim 4, wherein the alkylene component of the said oxyalkyleneoxy group comprises a chain of 3 to 6 consecutive carbon atoms or a chain of 4 to 28 carbon atoms which is interrupted by one or more ether oxygen atoms and the oxyaryleneoxy group is either an oxyphenyleneoxy group or a group of formula

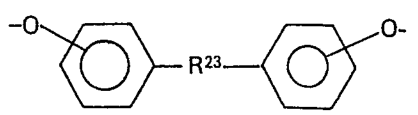

XII

wherein $R^{23}$ is a carbon-carbon bond, an ether oxygen atom, a carbonyl group, a sulphonyl group, a methylene group, or an isopropylidene group.

6. A method according to claim 1, wherein each pair of $R^{19}$ is a group of formula $-C(R^{21}R^{22})CO-$, wherein $R^{21}$ is a methyl, ethyl, n-propyl, n-pentyl, neopentyl, sec-amyl, or 2-ethylhexyl group and $R^{22}$ is a methyl group, or $R^{21}$ and $R^{22}$ together are pentamethylene or hexamethylene.

7. A method according to claim 1, in which (b) is a diglycidyl ether of a polyhydric phenol or an advancement product of such a diglycidyl ether, or is a water-soluble N,N-diglycidyl compound.

8. A method according to claim 1, in which the cellulosic fibres are also impregnated with a heat-curing amount of a heat-curing agent for (b).

9. A method according to claim 1, in which the water-borne composition contains 2 to 30% by weight of water.

10. A method of producing a composite article, which method comprises heat curing a prepreg prepared by the method according to claim 1.

## Revendications

1. Procédé de fabrication de pré-imprégnés, caractérisé en ce qu'on imprègne des fibres contenant de la cellulose avec une composition aqueuse constituée (a) d'une résine photopolymérisable et (b) d'une résine époxydique, puis on expose les fibres imprégnées à un rayonnement actinique de telle façon que (a) soit photopolymérisée, la résine (a) répondant à la formule VIII:

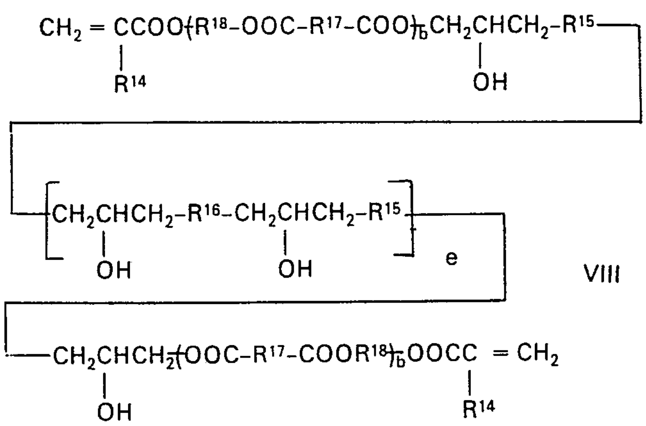

VIII

dans laquelle:
b est égal à 0 ou à 1, e représente un nombre entier au moins égal à 1, les $R^{14}$ représentent chacun un atome d'hydrogène ou un radical méthyle, les $R^{15}$ représentent chacun le radical bivalent qui subsiste lorsque, d'un composé contenant deux radicaux glycidyles directement liés à un ou à deux atomes d'oxygène, d'azote ou de soufre, on élimine ces radicaux glycidyles, $R^{16}$ représentent chacun le radical divalent que laisse un diol, un diphénol, un acide dicarboxylique ou un composé contenant deux radicaux pris dans l'ensemble des radicaux amides et imides lorsqu'on l'ampute de deux atomes d'hydrogène terminaux liés à un ou à deux atomes d'oxygène ou d'azote, les $R^{17}$ représentent chacun un radical alkylène contenant de 1 à 6 atomes de carbone, un radical alcénylène contenant de 2 à 10 atomes de carbone, un radical arylène contenant de 6 à 10 atomes de carbone ou un radical cycloalkylène ou cycloalcénylène contenant de 5 à 8 atomes de carbone, et les $R^{18}$ représentent chacun un radical divalent aliphatique, cycloaliphatique ou araliphatique contenant de 2 à 8 atomes de carbone, avec la condition qu'au moins 25% de la somme des (e+1) radicaux $R^{15}$ et des e radicaux $R^{16}$ soient chacun un radical de formule IX:

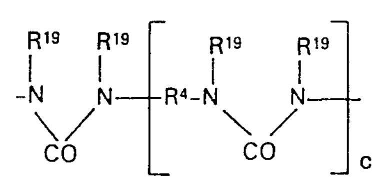

IX

ou un radical de formule X:

$$-O(OC)_d-R^{20}-(CO)_d-O- \qquad (X),$$

formules dans lesquelles $R^4$ représente un radical divalent aliphatique, cycloaliphatique ou araliphatique contenant de 1 à 8 atomes de carbone, les $R^{19}$ représentent chacun un radical alkyle contenant de 1 à 4 atomes de carbone ou représentent, par paire, un radical de formule $-CH^2CH^2-$, $-CH_2CH_2-$, $-C(R^{21}R^{22})CO-$, 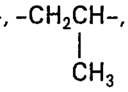

$-CH^2CH^2CH^2-$ ou $-COCO-$, c et d sont égaux chacun à 0 ou à 1, $R^{20}$ représente un radical aliphatique linéaire ou ramifié qui contient de 2 à 20 atomes de carbone ou, lorsque tous les d sont égaux à 1, peut aussi représenter un radical de formule XI:

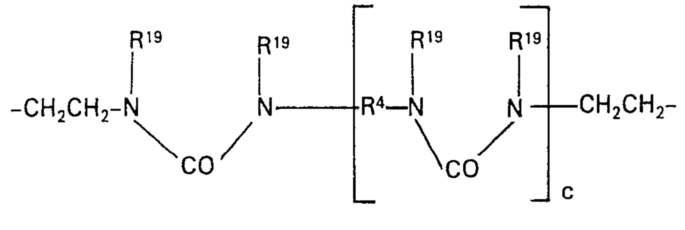 XI

et $R^{21}$ et $R^{22}$ représentent soit chacun un atome d'hydrogène ou un radical alkyle linéaire ou ramifié qui contient au plus 9 atomes de carbone, soit, ensemble, un radical tétraméthylène, pentaméthylène, méthyl-pentaméthylène ou hexaméthylène.

2. Procédé selon la revendication 1, caractérisé en ce que e représente un nombre entier de 1 à 10.

3. Procédé selon la revendication 1, caractérisé en ce que $R^{20}$ représente un radical alkylène qui contient au plus 9 atomes de carbone et qui est éventuellement interrompu par un ou plusieurs radicaux carbonyloxy ou un ou plusieurs atomes d'oxygène de fonction éther.

4. Procédé selon la revendication 1, caractérisé en ce qu'au plus 75% de la somme des (e+1) radicaux $R^{15}$ et des e radicaux $R^{16}$ représentent un radical de formule IX ou un radical de formule X dans lequel d est égal à 1, et au moins 25% des radicaux $R^{15}$ et $R^{16}$ représentent un radical oxy-alkylène-oxy contenant de 2 à 40 atomes de carbone (dont la chaîne est éventuellement interrompue par un ou plusieurs atomes d'oxygène de fonction éther) ou un radical oxy-arylène-oxy contenant de 6 à 18 atomes de carbone.

5. Procédé selon la revendication 4, caractérisé en ce que la composante alkylène dudit radical oxy-alkylène-oxy contient une chaîne comportant de 3 à 6 atomes de carbone qui se suivent ou une chaîne comportant de 4 à 28 atomes de carbone et interrompue par un ou plusieurs atomes d'oxygène de fonction éther, et le radical oxy-arylène-oxy est soit un radical oxy-phénylène-oxy, soit un radical répondant à la formule XII:

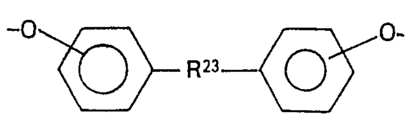 XII

dans laquelle $R^{23}$ représente une liaison carbone-carbone, un atome d'oxygène de fonction éther, un radical carbonyle, un radical sulfonyle, un radical méthylène ou un radical isopropylidène.

6. Procédé selon la revendication 1, caractérisé en ce qu'un couple de radicaux $R^{19}$ forme un radical répondant à la formule:

$$-C(R^{21}R^{22})CO-$$

dans laquelle $R^{21}$ représente un radical méthyle, éthyle, n-propyle, n-pentyle, néopentyle, sec-pentyle ou éthyl-2 hexyle et $R^{22}$ représente un radical méthyle, ou encore $R^{21}$ et $R^{22}$ forment ensemble un radical pentaméthylène ou hexaméthylène.

7. Procédé selon la revendication 1, caractérisé en ce que la résine (b) est un éther diglycidylique d'un polyphénol, un produit de pré-alongement d'un tel éther diglycidylique, ou un composé N,N-diglycidylique soluble dans l'eau.

8. Procédé selon la revendication 1, caractérisé en ce que les fibres contenant de la cellulose sont en outre imprégnées avec une quantité efficace, du point de vue du durcissement, d'un thermodurcisseur pour (b).

9. Procédé selon la revendication 1, caractérisé en ce que la composition aqueuse contient de 2 à 30% en poids d'eau.

10. Procédé de fabrication d'objets stratifiés, caractérisé en ce qu'on thermodurcit un pré-imprégné qui a été fabriqué par le procédé selon la revendication 1.